# EUROPEAN PATENT APPLICATION

(11) **EP 3 731 360 A1**
(43) Date of publication of application: **28.10.2020**
(21) Application number: 18891583.9
(22) Date of filing: 13.12.2018
(51) Int. Cl.: H02G 3/32, F16L 3/12, G02B 6/46, H05K 7/00

(54) **CORD CLAMP**

(30) Priority: 19.12.2017 JP 2017242616
(71) Applicant: SUMITOMO ELECTRIC INDUSTRIES, LTD., Osaka-shi, Osaka 541-0041 (JP)
(72) Inventor: OKI, Eisuke, Komaki-shi, Aichi 485-0831 (JP); IMAKAWA, Tomomi, Komaki-shi, Aichi 485-0831 (JP); SATO, Shinsuke, Komaki-shi, Aichi 485-0831 (JP); YAMAUCHI, Takayasu, Osaka-shi, Osaka 541-0041 (JP)
(74) Representative: Hoffmann Eitle
(86) International application number: PCT/JP2018/045800
(87) International publication number: WO 2019/124198

(57) **Abstract**

A cord clamp includes: two plate sections provided in parallel in a longitudinal direction; and a base plate section that connects one end sections of the plate section in the longitudinal direction. When a surface on the side where the two plate sections face each other is defined as an inside surface, and a surface on an opposite side of the inside surface is defined as an outside surface, a step a surface of which is shifted in a direction intersecting a plane formed by a cord insertion direction in which a cord passes between the plate sections and the longitudinal direction is provided on each of the inside surface and the outside surface, a location in the cord insertion direction where the step of the inside surface is provided and a location in the cord insertion direction where the step of the outside surface is provided are equal to or greater than a plate thickness of the plate section and equal to or less than three times the plate thickness thereof.

## Description

### TECHNICAL FIELD

The present disclosure relates to a cord clamp.

The present application claims the benefit of priority of Japanese Patent Application No. 2017-242616, filed on December. 19, 2017, the content of which is incorporated herein by reference.

### BACKGROUND ART

Patent Literatures 1 to 3 disclose a cable clamp (a holding tool) for holding an optical cable and an electric cable.

### CITATION LIST

### PATENT LITERATURE

Patent Literature 1: Japanese Patent Application No. 09-135086
Patent Literature 2: Japanese Design Registration No. 0541515
Patent Literature 3: Japanese Design Registration No. 0951321

### SUMMARY OF INVENTION

A cord clamp according to one aspect of the present disclosure includes: two plate sections provided in parallel in a longitudinal direction at a predetermined gap; and a base plate section provided to connect one end sections of the two plate sections in the longitudinal direction. When a surface on the side where the two plate sections face each other is defined as an inside surface, and a surface on an opposite side of the inside surface is defined as an outside surface, the two plate sections include a step, a surface of which is shifted in a direction intersecting a plane formed by a cord insertion direction in which a cord passes between the two plate sections and the longitudinal direction, and which is provided on each of the inside surface and the outside surface, a location in the cord insertion direction where the step of the inside surface is provided and a location in the cord insertion direction where the step of the outside surface is provided are shifted by a predetermined distance, and the predetermined distance is equal to or greater than a plate thickness of the two plate sections and equal to or less than three times the plate thickness thereof.

### BRIEF DESCRIPTION OF DRAWINGS

Fig. 1 is a perspective view illustrating an appearance of a cord clamp according to a first embodiment of the present disclosure, and is a perspective view observed from a front and lower side in a case where a lid section is in an open state.
Fig. 2 is a perspective view of the cord clamp of Fig. 1 observed from a rear and lower side.
Fig. 3 is a perspective view when the lid section of the cord clamp of Fig. 1 is in a closed state.
Fig. 4 is a cross-sectional view taken along the line A-A of Fig. 1.
Fig. 5 is a cross-sectional view taken along the line B-B of Fig. 1.
Fig. 6 is a cross-sectional view of a plate section of Fig. 5.
Fig. 7 is a schematic diagram illustrating a configuration of a step portion in the plate section.
Fig. 8 is a schematic diagram illustrating a desirable configuration of the step portion in the plate section.
Fig. 9 is a diagram illustrating a mounting section of a base plate section.
Fig. 10 is a diagram illustrating the cord clamp mounted on a rack (a termination rack).
Fig. 11 is a diagram illustrating a comparative example of the cord clamp.
Fig. 12 is a perspective view illustrating an appearance of a cord clamp according to a second embodiment of the present disclosure, and is a view observed from a front and upper side in a case where a lid section is in an open state.
Fig. 13 is a perspective view of a main body section in which a guide section structure is detached from the cord clamp of Fig. 12, which is observed from the front and upper side.
Fig. 14 is a perspective view of the guide section structure of the cord clamp of Fig. 12, which is observed from the front and upper side.

### DESCRIPTION OF EMBODIMENTS

### [Technical Problem]

For example, as described in the cable clamps described in Patent Literatures 1 to 3, a clamp for holding a cord includes two plate sections formed of resin arranged in parallel in a longitudinal direction, and a plate section formed of resin so as to connect the two plate sections, and has a structure in which the cord (a cable) is inserted into a portion surrounded by these plate sections.

Meanwhile, when a length (a height of the plate section) in a direction (a longitudinal direction) orthogonal to a cord insertion direction of the plate section is lengthened, the two plate sections are easily bent in a third direction orthogonal to the cord insertion direction and a direction (the longitudinal direction or a height direction) orthogonal to the cord insertion direction at the time of performing resin molding. Therefore, there is a possibility that the holding of the cord may be hindered. Here, a fact that the two plate sections are bent in the third direction indicates that a gap between the plate sections in the third direction is shifted from a designed value.

An object of the present disclosure is to provide a cord clamp in which two plate sections are not easily bent in a third direction orthogonal to a cord insertion direction and a direction (a longitudinal direction or a height direction) orthogonal to the cord insertion direction, when the cord clamp having a long length in the direction (the longitudinal direction or the height direction) orthogonal to the cord insertion direction of the plate section is molded with resin in the cord clamp having the two plate sections formed in parallel in the longitudinal direction.

### [Advantageous Effects of the Present Disclosure]

According to the present disclosure, it is possible to provide a cord clamp in which two plate sections are not easily bent in a third direction orthogonal to a cord insertion direction and a direction (a longitudinal direction or a height direction) orthogonal to the cord insertion direction, when the cord clamp having a long length in the direction (the longitudinal direction or the height direction) orthogonal to the cord insertion direction of the plate section is molded with resin in the cord clamp having the two plate sections formed in parallel in the longitudinal direction.

### (Description OF Embodiments of the Present Disclosure)

First, embodiments of the present disclosure will be listed and described.

A cord clamp according to one aspect of the present disclosure includes:
(1) two plate sections provided in parallel in a longitudinal direction at a predetermined gap; and
   a base plate section provided to connect one end sections of the two plate sections in the longitudinal direction. When a surface on the side where the two plate sections face each other is defined as an inside surface, and a surface on the opposite side of the inside surface is defined as an outside surface, the two plate sections include a step, the surface of which is shifted in a direction intersecting a plane formed by a cord insertion direction in which a cord passes between the two plate sections and the longitudinal direction, and which is provided on each of the inside surface and the outside surface, a location in the cord insertion direction where the step of the inside surface is provided and a location in the cord insertion direction where the step of the outside surface is provided are shifted by a predetermined distance, and the predetermined distance is equal to or greater than a plate thickness of the two plate sections and equal to or less than three times the plate thickness thereof.
   According to the above-described configuration, the location of the step of the inside surface of the plate section and the location of the step of the outside surface are shifted in the cord insertion direction. The distance between the two steps with respect to the cord insertion direction is equal to or greater than the plate thickness of the plate section and equal to or less than three times the plate thickness thereof.
   Accordingly, when a cord clamp having a long length in a direction (a longitudinal direction or a height direction) orthogonal to the cord insertion direction is molded with resin, the two plate sections can be hardly bent in a third direction orthogonal to the cord insertion direction and the direction (the longitudinal direction or the height direction) orthogonal to the cord insertion direction.
(2) On one side surface of the base plate section, a step may be provided so as to be continuous with the step of the inside surface of the two plate sections, and on the other side surface thereof, a step may be provided so as to be continuous with the step of the outside surface of the two plate sections.

According to the above-described configuration, since the step of the two plate sections and the step of the base plate section are provided continuously, the two plate sections can be further surely hardly bent when the cord clamp having the long length in the direction (the longitudinal direction or the height direction) orthogonal to the cord insertion direction is molded with resin.

### (Details of Embodiments of the Present Disclosure)

A specific example of a cord clamp according to an embodiment of the present disclosure will be described hereinafter with reference to the drawings. In the drawing of each embodiment, a "left and right direction", a "front and rear direction", and an "up and down direction" are relative directions set for the convenience of description.

The present invention is not limited thereto, but is indicated by the scope of the claims, and is intended to include all the modifications within meanings equivalent to the scope of the claims, and the scope.

### (First Embodiment)

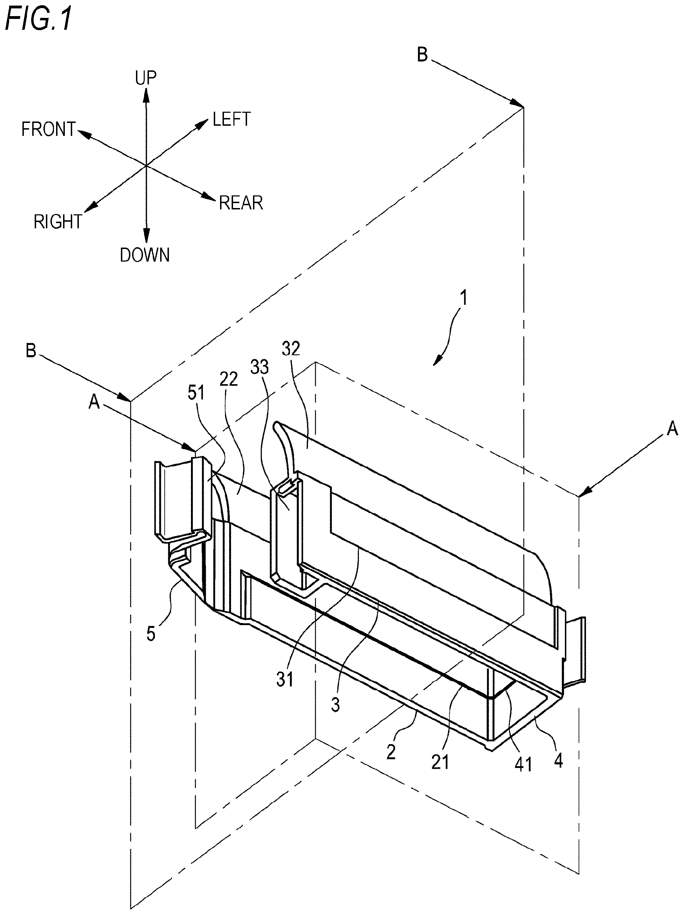

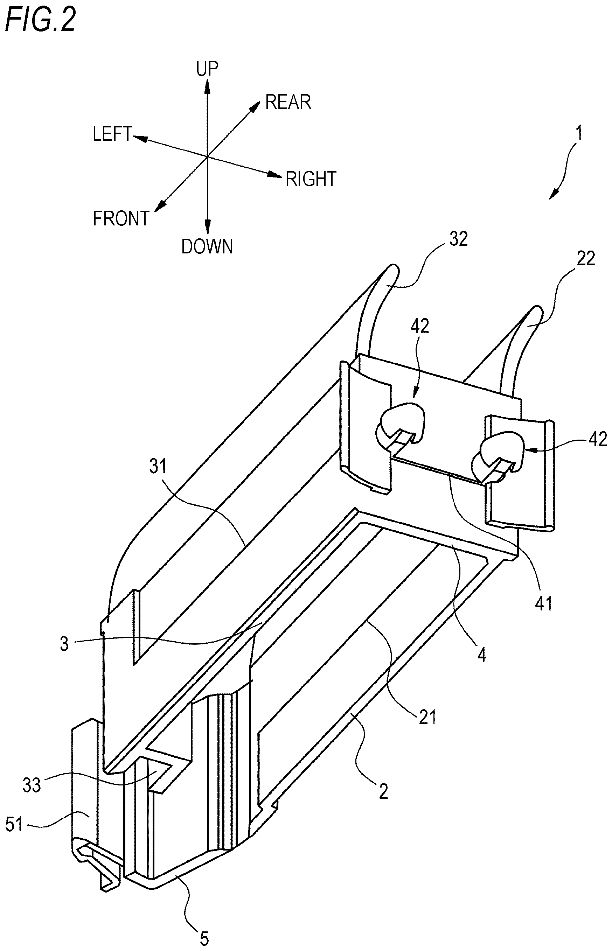

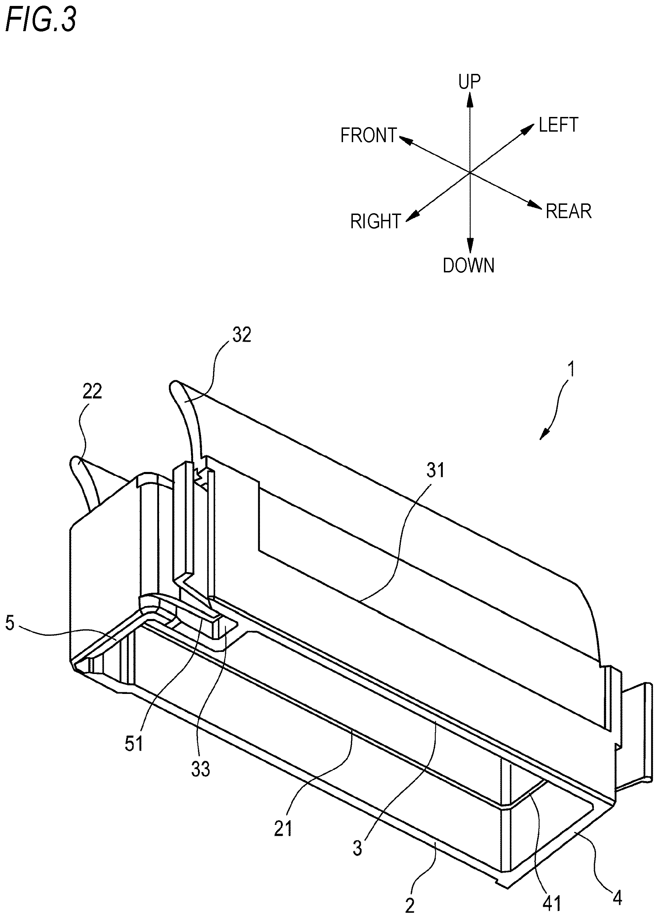

Fig. 1 is a perspective view illustrating an appearance of a cord clamp according to a first embodiment of the present disclosure, and is a perspective view observed from a front and lower side in a case where a lid section is in an open state. Fig. 2 is a perspective view of the cord clamp of Fig. 1 observed from a rear and lower side. Fig. 3 is a perspective view when the lid section of the cord clamp of Fig. 1 is in a closed state.

As illustrated in Fig. 1, a cord clamp 1 includes two plate sections 2 and 3 disposed to face each other, and a base plate section 4 for connecting one end sections of the two plate sections 2 and 3 to each other, and a lid section 5 that can connect the other end sections of the two plate sections 2 and 3 to each other. The cord clamp 1 is mounted on a rack (a termination rack) together with, for example, a connection section (a connector and an adapter) between cords (cables) that are performed with termination processing, and a tray in which a splicing section between the cords is housed, and regulates a location of the cord pulled out from the tray.

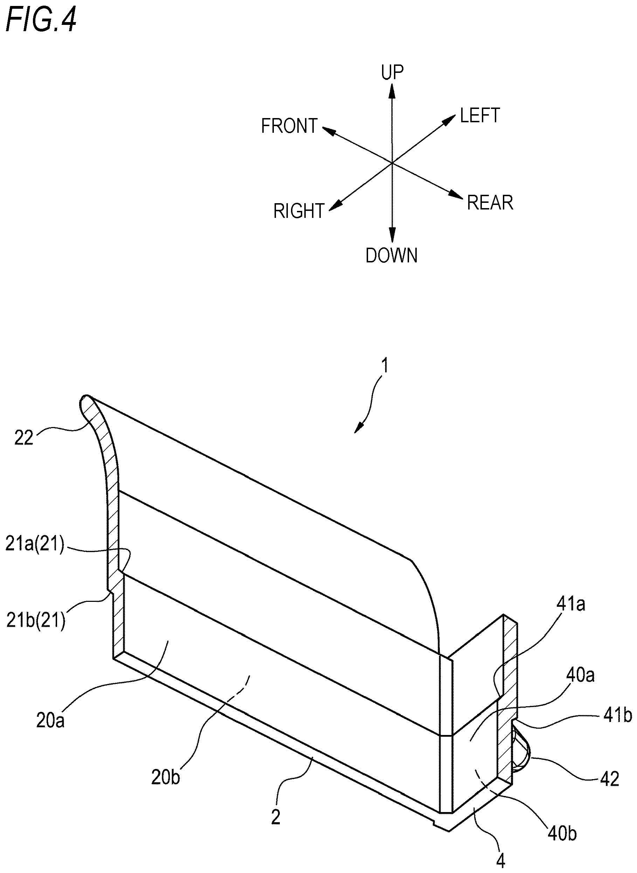

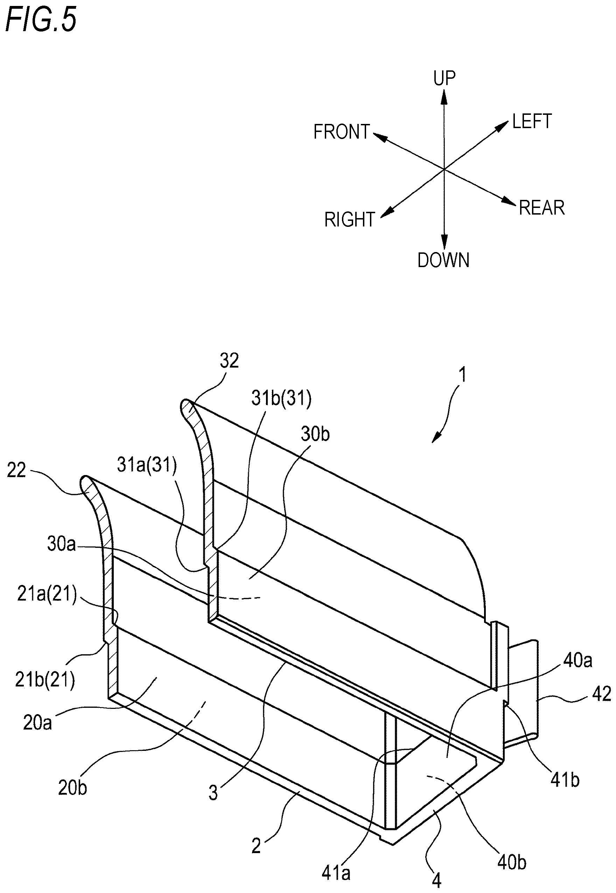

The plate sections 2 and 3 are provided in parallel in the front and rear direction (a longitudinal direction) in Fig. 1 at a predetermined gap in the left and right direction of the cord clamp 1. A step 21 extending in the front and rear direction is formed on a side surface of the plate section 2, and a step 31 extending in the front and rear direction is formed on a side surface of the plate section 3 (the steps 21 and 31 will be described later with reference to Figs. 4 and 5).

Guide sections 22 and 32 for guiding the cord passing through the cord clamp 1 in a predetermined direction are respectively provided at upper end sections of the plate sections 2 and 3. The guide sections 22 and 32 are formed in circular arc shapes that are gently bent in the same direction as the direction in which the cord is guided. For example, the guide sections 22 and 32 are bent at the same curvature. In the embodiment, the cord clamp 1 including the guide sections 22 and 32 is illustrated, and a cord clamp having a structure not including the guide sections 22 and 32 may be used.

A recessed section 33 with which a part of the lid section 5 can be engaged is formed at a front end section of the plate section 3 on the left side. For example, the recessed section 33 is formed in a shape having an opening toward the front side.

The base plate section 4 is provided so as to connect one end sections on the rear side of the two plate sections 2 and 3 in the longitudinal direction. A step 41 extending in the left and right direction is formed on a side surface of the base plate section 4 (the step 41 will be described later with reference to Figs. 4 and 5).

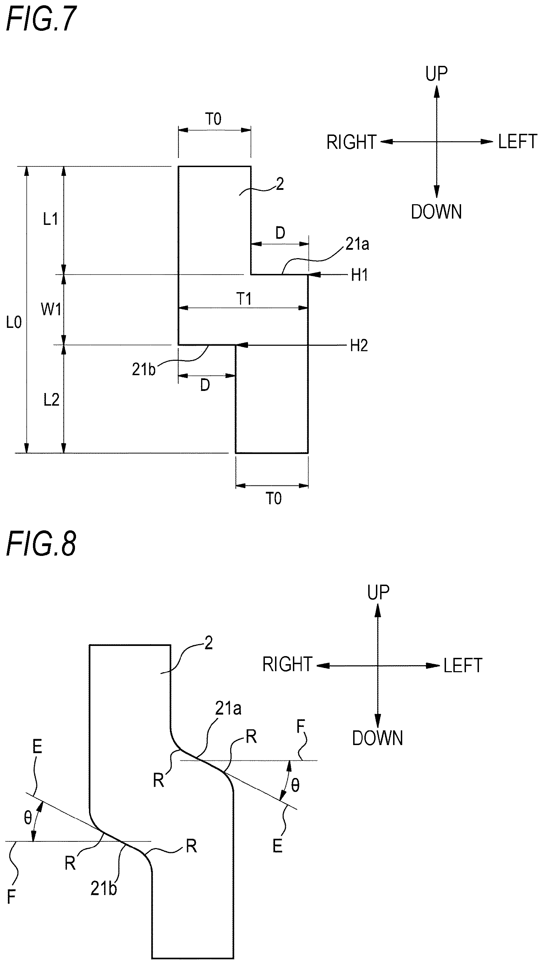

A mounting section 42 for mounting the cord clamp 1 on the rack is provided on a rear side surface of the base plate section 4 (the mounting section 42 will be described later with reference to Fig. 7).

The lid section 5 is provided so as to be able to connect one end sections on the side (the front side in the drawing) opposite to the side where the base plate section 4 is provided in the longitudinal direction of the two plate sections 2 and 3. The lid section 5 is connected to the front end section of the right side plate section 2. The lid section 5 is provided rotatably around the up and down direction at the front end section of the plate section 2 as an axis. When the lid section 5 rotates, a space between the front side end sections of the plate sections 2 and 3 becomes in an open state (refer to Figs. 1 and 2) or a closed state (refer to Fig. 3). A protruding section 51 is formed at an end section of the lid section 5. The lid section 5 is configured to be in the closed state by engaging the protruding section 51 with the recessed section 33 of the plate section 3.

The cord clamp 1 is formed of, for example, polycarbonate (PC), polypropylene (PP), and a material obtained by adding a glass fiber to PC or PP.

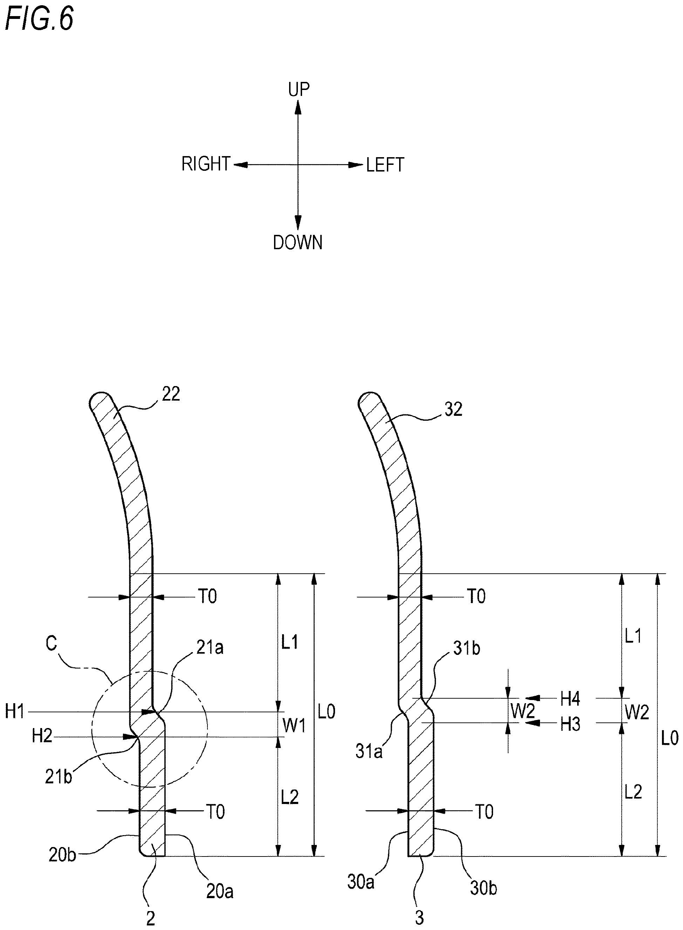

Next, the steps 21 and 31 of the plate sections 2 and 3 will be described with reference to Figs. 4 to 8. Fig. 4 is a cross-sectional view taken along the line A-A of the cord clamp 1 illustrated in Fig. 1. In the same manner, Fig. 5 is a cross-sectional view taken along the line B-B of the cord clamp 1. Fig. 6 is a cross-sectional view of the plate sections 2 and 3 illustrated in Fig. 5. Fig. 7 is a schematic diagram illustrating a configuration of a step portion C in the plate section 2. Fig. 8 is a schematic diagram illustrating a desirable configuration of the step portion C in the plate section 2.

Here, in the two plate sections 2 and 3, a surface on the side where the plate sections 2 and 3 face each other is defined as an inside surface, and an inside surface 20a of the plate section 2 and an inside surface 30a of the plate section 3 are defined. A surface on the side opposite to the inside surfaces 20a and 30a is defined as an outside surface, and an outside surface 20b of the plate section 2 and an outside surface 30b of the plate section 3 are defined.

The step 21 of the plate section 2 is provided on each of the inside surface 20a and the outside surface 20b. The step 31 of the plate section 3 is provided on each of the inside surface 30a and the outside surface 30b. The steps 21 and 31 are formed by shifting the surfaces in a direction (the left and right direction in the drawing) intersecting a plane formed by a cord insertion direction (the up and down direction in the drawing) in which the cord passes between the two plate sections 2 and 3 and the longitudinal direction (the front and rear direction in the drawing) of the plate sections 2 and 3.

A step 21a formed on the inside surface 20a of the plate section 2 is provided along the longitudinal direction (the front and rear direction in the drawing) of the inside surface 20a. A step 21b formed on the outside surface 20b of the plate section 2 is provided along the longitudinal direction (the front and rear direction in the drawing) of the outside surface 20b. In the same manner, a step 31a formed on the inside surface 30a of the plate section 3 is provided along the longitudinal direction (the front and rear direction in the drawing) of the inside surface 30a. A step 31b formed on the outside surface 30b of the plate section 3 is provided along the longitudinal direction (the front and rear direction in the drawing) of the outside surface 30b.

As illustrated in Fig. 6, a location H1 in the cord insertion direction where the step 21a of the inside surface 20a in the plate section 2 is provided is shifted by a distance W1 with respect to a location H2 in the cord insertion direction where the step 21b of the outside surface 20b is provided. In the same manner, a location H3 in the cord insertion direction where the step 31a of the inside surface 30a in the pate section 3 is provided is shifted by a distance W2 with respect to a location H4 in the cord insertion direction where the step 31b of the outside surface 30b is provided. The shift distances W1 and W2 are set to be equal to or greater than 1 time and equal to or less than 3 times a thickness T0 of the plate sections 2 and 3 (in this example, the thicknesses of the plate sections 2 and 3 are the same as each other).

As illustrated in Figs. 6 and 7, when a length of the plate section 2 in the cord insertion direction (the up and down direction) is defined as L0, a length from an upper end of the plate section 2 to the step 21a is defined as L1, and a length from the step 21b to a lower end of the plate section 2 is defined as L2, the steps 21a and 21b are provided in a range where 0.25 ≤ L1 / L0 and 0.25 ≤ L2 / L0. That is, a step section (a portion from the location H1 of the step 21a to the location H2 of the step 21b) is provided so as to be located within a range of 50% of a central portion in the up and down direction of the plate section 2. The length L0 of the plate section 2 indicates a length of a portion excluding the guide section 22.

As illustrated in Fig. 7, a plate thickness T1 of the plate section 2 from the location H1 of the step 21a to the location H2 of the step 21b is formed to be thicker than a plate thickness T0 of the plate section 2 having no step 21 (21a and 21b). When a size (a depth) of the steps 21a and 21b is defined as D, the size D is set to satisfy 0.2 ≤ D / T0 ≤ 1.5. That is, the plate thickness T1 of the plate section 2 at the portion where the steps 21a and 21b are provided is set to be equal to or greater than 1.2 times the plate thickness T0 and equal to or less than 2.5 times.

For example, as illustrated in Fig. 8, the steps 21a and 21b of the plate section 2 are desirably formed in a shape in which R is applied to two corners forming the steps. In each of the steps 21a and 21b, an angle θ of a boundary of the step section formed by a line E connecting the centers of the two Rs (curved surfaces) and a line F in the left and right horizontal direction is set to satisfy 30 degrees ≤ θ ≤ 60 degrees.

Figs. 7 and 8 illustrate only the plate section 2, and in the same manner, the lengths L1 and L2 of the plate section 3, the size D of the steps 31a and 31b, and the angle θ are also set for the plate section 3. In the above-described plate sections 2 and 3, the directions of the steps 21 (21a and 21b) and 31 (31a and 31b) are formed so as to become the left direction opposite to the bending directions of the guide sections 22 and 32, and for example, may be formed so as to be the same right direction as the bending directions of the guide sections 22 and 32.

Next, the step 41 of the base plate section 4 will be described with reference to Figs. 4 and 5. In the base plate section 4, a side surface (a rear side surface) on the side where the mounting section 42 is provided is defined as a rear side surface 40b, and a side surface on the side opposite to the rear side surface 40b is defined as a front side surface 40a.

The step 41 of the base plate section 4 is provided on each of the front side surface 40a and the rear side surface 40b. The step 41 is formed by shifting its surface in a direction (the front and rear direction in the drawing) intersecting a plane formed by a cord insertion direction (the up and down direction in the drawing) of the base plate section 4 and a left and right direction of the base plate section 4.

A step 41a formed on the front side surface 40a of the base plate section 4 is provided along the left and right direction of the front side surface 40a. A step 41b formed on the rear side surface 40b of the base plate section 4 is provided along the left and right direction of the rear side surface 40b. The step 41a is provided so as to be continuous with the step 21a of the inside surface 20a of the plate section 2 and the step 31a of the inside surface 30a of the plate section 3. The step 41b is provided so as to be continuous with the step 21b of the outside surface 20b of the plate section 2 and the step 31b of the outside surface 30b of the plate section 3.

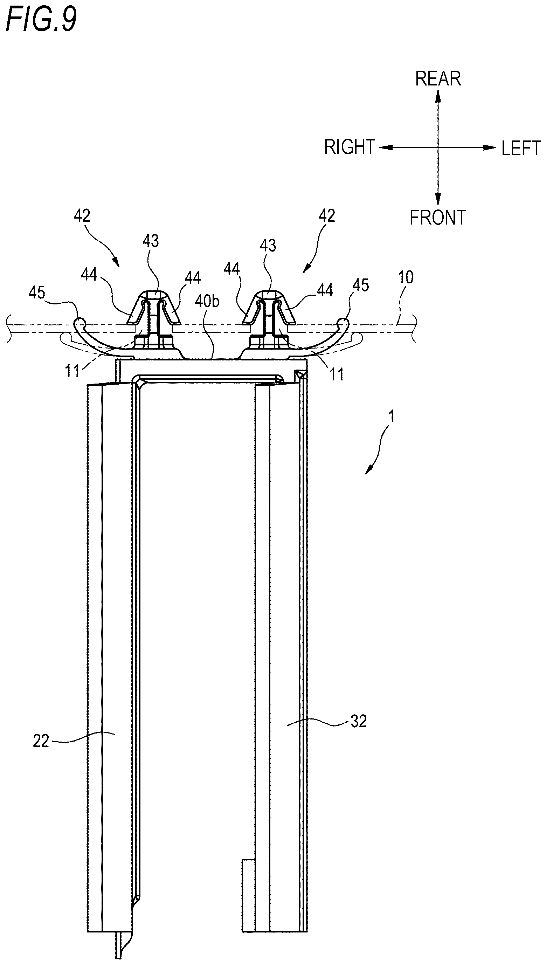

Next, the mounting section 42 of the base plate section 4 will be described with reference to Fig. 9. As illustrated in Fig. 9, the two mounting sections 42 are provided on the rear side surface 40b of the base plate section 4 side by side in the left and right direction. The mounting section 42 includes a protrusion 43 having a return section 44 capable of being elastically deformed, and a pressing section 45 having a curved shape and capable of being elastically deformed. By inserting the protrusion 43 of the mounting section 42 into the mounting hole 11 formed in the rack 10, the rack 10 is sandwiched by elasticity of the return section 44 and the pressing section 45, and the cord clamp 1 is fixed to the rack 10.

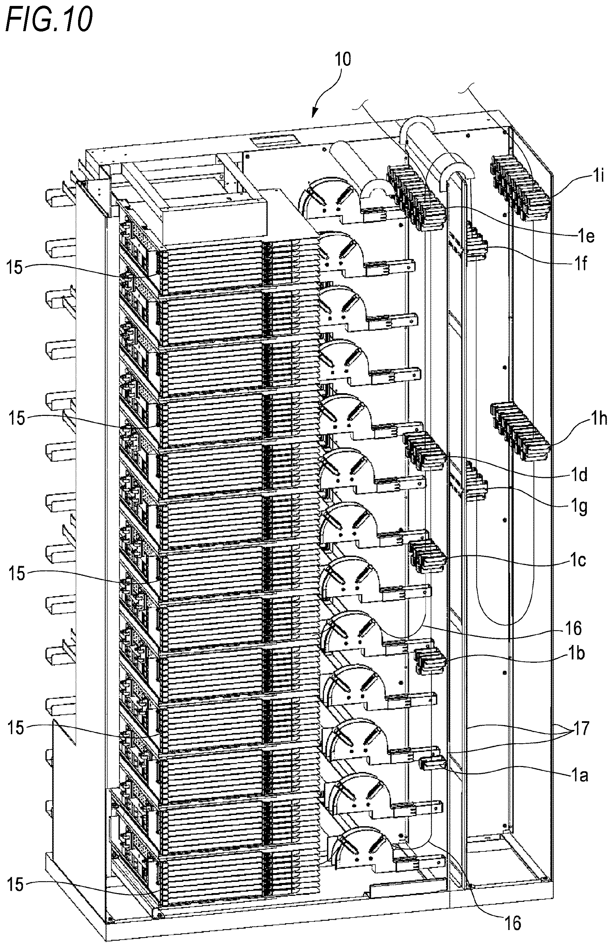

Fig. 10 illustrates cord clamp rows 1a to 1i by the cord clamp 1 mounted on the rack 10. As illustrated in Fig. 10, a plurality of stages of trays 15 are stacked in the up and down direction and housed in the rack 10. A cord 16 is pulled out from the tray 15 of each stage, and the pulled-out cord 16 is clamped to the respective cord clamps 1 of the cord clamp rows 1a to 1i. For the easy view of the drawing, only the two cords 16 pulled out from some of the trays 15 are illustrated here, and actually, a large number of cords are pulled out from the trays 15 of the respective stages.

For example, the cord clamp rows 1a to 1i are mounted on a partition plate 17 of the rack 10 along a direction in which the cord 16 is pulled out. In order to secure a bending radius when wiring the cord to a cable guide (not illustrated) installed on the rack 10, the cord clamp 1 having a structure including the guide sections 22 and 32 bent in the direction of the cable guide (in the example of Fig. 10, a depth direction of the rack 10) is mounted on the cord clamp rows 1e and 1i at the top of the rack 10. Except a fact that the guide sections 22 and 32 are not provided, a cord clamp having the same structure as that of the cord clamp 1 is mounted on sections other than the uppermost section.

In order to derive the cords at a high density, the adjacent cord clamps in the cord clamp rows 1a to 1i at each stage may be arranged in a staggered arrangement in which the cord clamps are vertically shifted. As described above, the cord clamp 1 having the structure including the guide sections 22 and 32 is mounted on the uppermost cord clamp rows 1e and 1i. Meanwhile, when the uppermost cord clamp rows 1e and 1i are arranged in the staggered arrangement, the arc-shaped guide sections 22 and 32 of the lower cord clamp in the staggered arrangement interfere with the adjacent upper cord clamps. Therefore, a gap between the cord clamp rows becomes wide. Therefore, it is desirable that the lower cord clamp in the staggered arrangement is designed as the cord clamp having the structure not including the guide sections 22 and 32, and the upper cord clamp is designed as the cord clamp 1 including the guide sections 22 and 32.

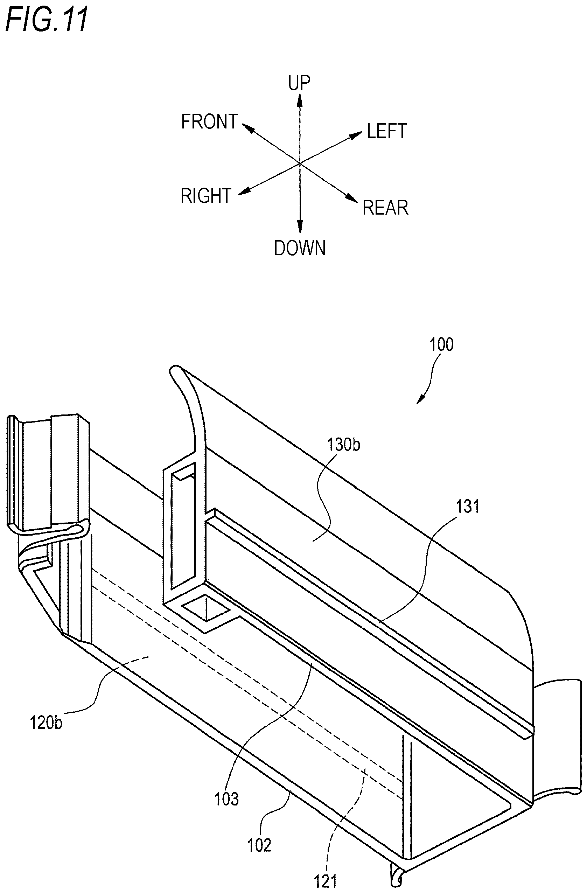

Fig. 11 is a perspective view illustrating an appearance of a cord clamp of a comparative example, and is a view observed from a front and lower side in a case where the lid section is in the open state which is the same as that of Fig. 1. As illustrated in Fig. 11, in a cord clamp 100 of the comparative example, a rib 121 is provided on an outside surface 120b of a plate section 102, and a rib 131 is provided on an outside surface 130b of a plate section 103. A thickness of the plate sections 102 and 103 at a portion where the ribs 121 and 131 are provided is formed to be the same as the plate thickness T1 of the plate section 2 at the portion where the step 21 (21a and 21b) is provided in the cord clamp 1 according to the above-described embodiment.

With respect to the difficulty of bending the plate section at the time of the resin molding, the comparison is performed between the cord clamp 100 having the above-described configuration and the cord clamp 1 according to the above-described embodiment. As a result, in the cord clamp 100 provided with the rib, the bending of the plate section (shift from a design value of the gap between the plate sections) is about 1.3 mm, whereas in the cord clamp 1 provided with the step, the bending of the plate section can be reduced to about 0.5 mm. It is considered that this is because the structure including the step is easier to flow resin during the molding than the structure including the rib, whereby residual stress after the molding can be reduced. The reason why the structure including the rib has a large residual stress is that it is considered that unevenness of pressure occurs during the molding at the portion where the rib is provided, and a molding shrinkage ratio and pressure propagation are uneven between the portion where the rib is provided and the portion where the rib is not provided, which causes a difference in cooling time.

In the first embodiment, as the cord clamp including the guide section, the cord clamp in which the guide section and the plate section are integrally formed is described, but the present invention is not limited thereto. For example, as shown in the following second embodiment, it is also possible to form the guide section separately and to assemble the guide section to the cord clamp having the structure not including the guide section.

### (Second embodiment)

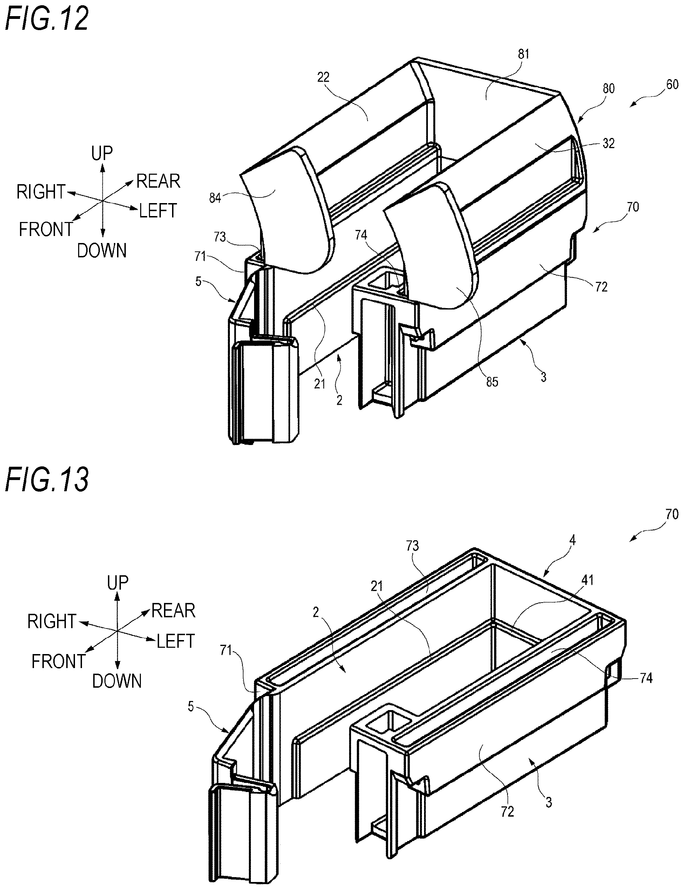

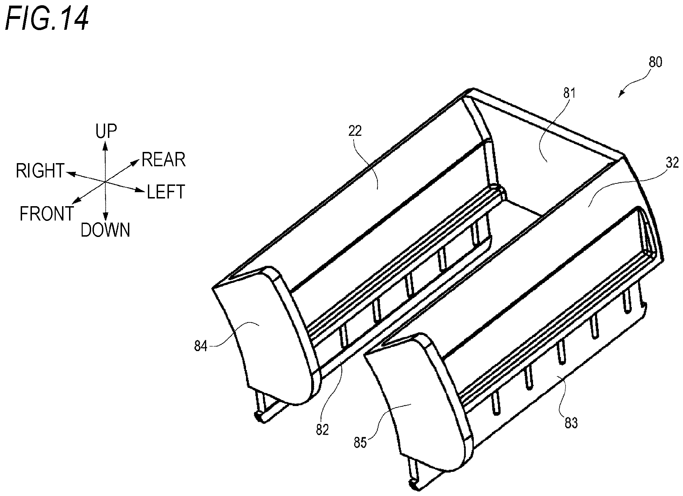

A cord clamp according to a second embodiment of the present disclosure will be described with reference to Figs. 12 to 14. The same components as those of the cord clamp 1 according to the first embodiment will be denoted by the same reference signs, and description thereof will be appropriately omitted. Fig. 12 is a perspective view illustrating an appearance of the cord clamp according to the second embodiment of the present disclosure, and is a perspective view observed from a front and upper side in a case where a lid section is in an open state. Fig. 13 is a perspective view of a main body section in which a guide section structure is detached from the cord clamp of Fig. 12, which is observed from the front and upper side. Fig. 14 is a perspective view of the guide section structure of the cord clamp of Fig. 12, which is observed from the front and upper side.

In a cord clamp 60 according to the second embodiment illustrated in Fig. 12, a main body section 70 illustrated in Fig. 13 and a guide section structure 80 illustrated in Fig. 14 are formed separately. The cord clamp 60 is formed by assembling the main body section 70 and the guide section structure 80.

As illustrated in Fig. 13, in the same manner as that of the cord clamp 1 according to the first embodiment, the main body section 70 includes two plate sections 2 and 3 disposed to face each other, and the base plate section 4 for connecting one end sections of the two plate sections 2 and 3 to each other, and the lid section 5 that can connect the other end sections of the two plate sections 2 and 3 to each other. The main body section 70 is provided with guide section fitting sections 71 and 72 along the longitudinal direction (the front and rear direction) of the main body section 70 so as to protrude to the outside of the plate sections 2 and 3, respectively. The guide section fitting sections 71 and 72 are respectively provided with guide section insertion grooves 73 and 74 that are provided along the front and rear direction so as to open upward.

As illustrated in Fig. 14, the guide section structure 80 is provided with the guide sections 22 and 32 for guiding the cord in a predetermined direction in the same manner as that of the first embodiment. A connection section 81 for connecting the guide sections 22 and 32 is provided at a rear end section of the guide sections 22 and 32. The guide section structure 80 is further provided with insertion sections 82 and 83 that can be inserted into the guide section insertion grooves 73 and 74 of the main body section 70. By inserting the insertion sections 82 and 83 into the guide section insertion grooves 73 and 74, the guide section structure 80 can be surely assembled to the main body section 70.

As described above, the cord clamp 60 according to the second embodiment has a structure in which the guide sections 22 and 32 are connected to each other by the connection section 81, and the insertion sections 82 and 83 are inserted into the guide section insertion grooves 73 and 74. The cord clamp 60 has the above-described structure. Accordingly, even though an own weight of the cord is applied to the guide sections 22 and 32, the guide section structure 80 is not easily detached from the main body section 70.

In this example, cord regulating sections 84 and 85 bent almost at right angles are respectively provided at the front end sections of the guide sections 22 and 32. The cord regulating sections 84 and 85 are provided thereat, whereby the cord can be regulated so as not to protrude in the front direction of the cord clamp 60. The cord clamp 1 according to the first embodiment may be provided with the same configuration as that of the cord regulating sections 84 and 85.

Each step (21, 31, and 41) in the cord clamp 60 according to the second embodiment has the same features as those of the first embodiment described with reference to Figs. 4 to 8. Therefore, the description thereof will be omitted. The base plate section 4 and the lid section 5 in the cord clamp 60 according to the second embodiment also have the same configurations as those of the first embodiment. The material is also the same as that of the first embodiment.

In the cord clamp 60 according to the second embodiment, the main body section 70 and the guide section structure 80 are separately formed as described above. Therefore, for example, after only the main body section 70 is mounted on the rack 10, the guide section structure 80 can be assembled to the main body section 70 as necessary. After the cord clamp 60 is mounted on the rack 10, only the guide section structure 80 can be also detached as necessary.

For example, when the cord clamp is mounted on the rack 10 illustrated in Fig. 10 described above, the main body section 70 is first mounted on all the cord clamp rows 1a to 1i. Only in the uppermost cord clamp rows 1e and 1i, the insertion sections 82 and 83 are inserted into the guide section insertion grooves 73 and 74 of the main body section 70. In this manner, the guide section structure 80 may be assembled to the main body section 70. When the uppermost cord clamp rows 1e and 1i are arranged in the staggered arrangement, only in the upper cord clamps in the staggered arrangement, the guide section structure 80 may be assembled to the main body section 70. In response to a change in a wiring state of the cord (for example, the number of wirings is small or large), the guide section structure 80 can be appropriately assembled or detached to or from a necessary portion.

In the cord clamp 60 according to the second embodiment, for example, the main body section 70 and the guide section structure 80 can be respectively manufactured by different molds at the time of manufacturing. Accordingly, the cord clamp 60 has a degree of freedom in a direction in which the mold is detached, and is easier to be manufactured by the mold than the integrated cord clamp 1 according to the first embodiment.

According to the configuration of the cord clamp 1 of the first embodiment or the cord clamp 60 of the second embodiment, the locations of the steps 21a and 31a of the inside surfaces 20a and 30a of the plate sections 2 and 3 and the locations of the steps 21b and 31b of the outside surfaces 20b and 30b are shifted in the cord insertion direction. The distance W1 between the step 21a and the step 21b and the distance W2 between the step 31a and the step 31b with respect to the cord insertion direction are equal to or greater than the plate thickness T0 of the plate sections 2 and 3 and equal to or less than three times the plate thickness T0. Accordingly, when the cord clamp 1 having the long length in the direction (the longitudinal direction or the height direction) orthogonal to the cord insertion direction is molded with resin, the plate sections 2 and 3 can be hardly bent in the third direction orthogonal to the cord insertion direction and the direction (the longitudinal direction or the height direction) orthogonal to the cord insertion direction.

The base plate section 4 is provided with the step 41 (41a and 41b) continuous with the steps 21 (21a and 21b) and 31 (31a and 31b) of the two plate sections 2 and 3. Therefore, the two plate sections 2 and 3 are supported by the base plate section 4, and when the cord clamp 1 having the long length in the direction (the longitudinal direction or the height direction) orthogonal to the cord insertion direction is molded with resin, the plate sections 2 and 3 can be further hardly bent.

Hereinabove, while the present disclosure is described in detail or with reference to specific embodiments, it is obvious to those skilled in the art that various changes and modifications can be made without departing from the spirit and scope of the present disclosure. The number, location, and shape of the components described above are not limited to the embodiments, and can be changed to the number, location, and shape suitable for performing the present disclosure.

### REFERENCE SIGNS LIST

- 1, 60:: cord clamp
- 1a to 1i:: cord clamp row
- 2, 3:: plate section
- 4:: base plate section
- 5:: lid section
- 10:: rack
- 20a, 30a:: inside surface
- 20b, 30b:: outside surface
- 21 (21a, 21b), 31(31a, 31b):: step
- 22, 32:: guide section
- 33:: recessed section
- 40a:: front side surface
- 40b:: rear side surface
- 41 (41a, 41b):: step
- 42:: mounting section
- 51:: protruding section
- 70:: main body section
- 71, 72:: guide section fitting section
- 73, 74:: guide section insertion groove
- 80:: guide section structure
- 81:: connection section
- 82, 83:: insertion section
- 84, 85:: cord regulating section
- T0, T1:: plate thickness

## Claims

1. A cord clamp, comprising:
two plate sections provided in parallel in a longitudinal direction at a predetermined gap; and
a base plate section provided to connect one end sections of the two plate sections in the longitudinal direction, wherein
when a surface on the side where the two plate sections face each other is defined as an inside surface, and a surface on an opposite side of the inside surface is defined as an outside surface, the two plate sections include a step, a surface of which is shifted in a direction intersecting a plane formed by a cord insertion direction in which a cord passes between the two plate sections and the longitudinal direction, and which is provided on each of the inside surface and the outside surface,
a location in the cord insertion direction where the step of the inside surface is provided and a location in the cord insertion direction where the step of the outside surface is provided are shifted by a predetermined distance, and
the predetermined distance is equal to or greater than a plate thickness of the two plate sections and equal to or less than three times the plate thickness thereof.

2. The cord clamp according to claim 1, wherein
on one side surface of the base plate section, a step is provided so as to be continuous with the step of the inside surface of the two plate sections, and
on the other side surface thereof, a step is provided so as to be continuous with the step of the outside surface of the two plate sections.
